# EUROPÄISCHE PATENTSCHRIFT

(11) **EP 1 169 899 B1**
(45) Veröffentlichungstag und Bekanntmachung des Hinweises auf die Patenterteilung: **27.11.2002**
(21) Anmeldenummer: 00934861.6
(22) Anmeldetag: 03.04.2000
(51) Int. Cl.: H05K 13/04

(54) **BESTÜCKKOPF MIT EINER VERDREHEINRICHTUNG FÜR ELEKTRISCHE BAUELEMENTE**
INSERTION HEAD WITH A TWISTING DEVICE FOR ELECTRICAL COMPONENTS
TETE DE MISE EN PLACE DE COMPOSANTS ELECTRIQUES, COMPORTANT UNE UNITE DE ROTATION

(30) Priorität: 21.04.1999 DE 19918056; 21.12.1999 DE 19961778
(43) Veröffentlichungstag der Anmeldung: 09.01.2002
(73) Patentinhaber: SIEMENS AKTIENGESELLSCHAFT, 80333 München (DE)
(72) Erfinder: MEHDIANPOUR, Mohammad, D-81829 München (DE); SCHULZ, Ralf, D-81241 München (DE); HUBER, Wolfgang, D-81379 München (DE)
(86) Internationale Anmeldenummer: DE0001025
(87) Internationale Veröffentlichungsnummer: WO00065893

(56) Entgegenhaltungen:
- EP-A- 0 691 805
- EP-A- 0 906 011
- FR-A- 2 661 309

## Beschreibung

Die Erfindung bezieht sich auf einen Bestückkopf mit zumindest einer Verdreheinrichtung für elektrische Bauelemente, wobei der revolverartige Bestückkopf einen Stator und einen Rotor aufweist, an eine Vielzahl von zirkulär verteilten Greifern in sich um eine Aufsetzachse drehbar gelagert sind, wobei der Bestückkopf eine optische Meßeinrichtung zur Lageerkennung der an den Greifern gehaltenen Bauelemente aufweist und
wobei die Bauelemente nach dem optischen Vermessen durch eine Feindreheinrichtung genau in die geforderte Aufsetzlage verdrehbar sind.

Durch die EP-A-0 906 011 ist ein revolverartiger Bestückkopf für elektrische Bauelemente mit einer Verdreheinrichtung bekannt geworden, die die Bauelemente nach dem optischen Vermessen genau in die geforderte Aufsetzlage verdreht.

Durch die EP-B 0 315 799 ist es ferner bekannt, eine Bestückvorrichtung mit einem verfahrbaren Revolverkopf zu versehen, bei dem die mit Saugpipetten versehenen Greifer an einem Rotor sternförmig abstehend angeordnet sind. Ein drehfester Stator des Bestückkopfes ist mit umlaufend verteilten Bearbeitungsstationen versehen.

Es ist üblich, eine dieser Stationen als optische Meßstation auszubilden, in der die Drehlage des zuvor aufgenommenen Bauelementes ermittelt wird. In einer nachfolgenden Verdrehstation wird die Lage des Bauelementes entsprechend der gewünschten Einbaulage verändert. Diese Veränderung beinhaltet eine Grobverdrehung z.B. in 45° Schritten entsprechend der gewünschten Einbaulage sowie eine Feinverdrehung, durch die die Abholungenauigkeit beim Aufnehmen der Bauelemente aus einer Zuführeinrichtung ausgeglichen wird.

Es ist ferner üblich, den Greifer mit einem scheibenartigen Drehkranz von relativ großem Durchmesser zu versehen. Auf diesen kann ein Reibrad der Dreheinrichtung radial aufgesetzt werden, worauf die Dreheinrichtung aktiviert wird und eine exakte Verdrehung des Greifers um einen vorberechneten Winkel bewirkt. Da die Bauelemente in unterschiedlicher Einbaulage auf die Leiterplatte aufzusetzen sind, kann der Drehwinkel so groß sein, daß der gesamte Drehzyklus länger dauert, als die Arbeitszyklen an anderen Stationen des Revolverkopfes, wodurch dessen Bestückleistung entsprechend begrenzt wird.

Der Erfindung liegt die Aufgabe zugrunde, den Zeitverlust beim Verdrehen der Greifer zu verringern.

Diese Aufgabe wird durch die Erfindung gemäß Anspruch 1 gelöst. Das Verdrehen des Greifers verteilt sich nun auf zwei Stufen, wobei die Grobverdrehung ohne besondere Genauigkeit zügig in einem Drehsegment vor optischen Meßeinrichtung erfolgt. Dadurch kann auch bei einem großen Gesamtdrehwinkel der Drehwinkel in der Feindreheinrichtung soweit verkürzt werden, daß die Feineinstellung nicht länger dauert als z.B. als das optische Vermessen in der Meßeinrichtung.

Vorteilhafte Weiterbildungen der Erfindung sind in den Unteransprüchen gekennzeichnet.

Durch die Weiterbildung nach Anspruch 2 erfolgt das Vermessen und das Feinverdrehen der Bauelemente im Stillstand. Die Meßstation und Feindrehstation wie auch die Grobdrehstation nach Anspruch 3 sind in einfacher Weise am Stator befestigt und können mit dem Bauelement bzw. mit dem Greifer eine präzise Wirkverbindung eingehen.

Durch die Reibfläche nach Anspruch 4 erfolgt die Grobdrehung während der ohnehin erforderlichen Vorwärtsbewegung des Greifers ohne jeden Zeitverlust. Die stationäre Reibfläche kann an einem einfachen Konstruktionsteil ausgebildet sein, an dem der Drehkranz solange abrollt, bis die gewünschte Endstellung zumindest annähernd erreicht ist. Die Eingriffslänge zwischen der Reibfläche und dem Drehkranz kann durch eine radiale Zustellbewegung der Verdreheinrichtung z.B. mit Hilfe von piezoelektrischen Antriebselementen von kurzer Reaktionszeit genau terminiert werden, so daß der Greifer um den berechneten Winkel verdreht werden kann.

Durch die Weiterbildung nach Anspruch 5 ist es möglich, die Grobverdrehung mit geringem Steuerungsaufwand durchzuführen.

Der Reibklotz nach Anspruch 6 stellt ein einfaches, leicht zu betatigendes Bauteil dar.

Durch die Weiterbildung nach Anspruch 7 ist es möglich, die Länge der Reibflächen so auszubilden, daß am Greifer jeweils ein Drehwinkel von z.B. 45° erreicht wird. Eine Vervielfachung des Drehwinkels wird durch eine entsprechende Anzahl der in die Bewegungsbahn des Drehkranzes schaltbar verstellten Reibklotze möglich.

Durch die Weiterbildung nach Anspruch 8 ist sichergestellt, daß die Greifer mit den Drehkränzen entlang einer genau definierten Bahn bewegt werden können. Zum Beispiel bewegen sich bei einem sternformigen Revolverkopf mit radial abstehenden Greifern die Drehkränze in einer Ebene, so daß auch die Reibklötze in einer Ebene angeordnet werden können, was mit Montagevorteilen verbunden ist. Durch die Verkürzung der Reiblänge wird sichergestellt, daß jede Reibfläche jeweils nur von einem Drehkranz belegt wird. Dadurch können diese je nach Vorgabe unterschiedlich und individuell verdreht werden.

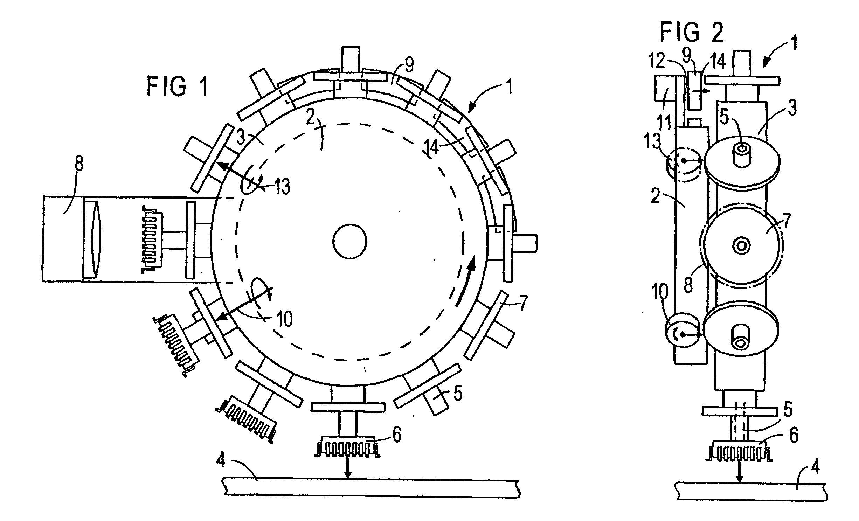

Im folgenden wird die Erfindung anhand eines in der Zeichnung dargestellten Ausführungsbeispieles näher erläutert.
- Figur 1: zeigt eine Seitenansicht eines Bestückkopfes zum Bestücken von elektrischen Leiterplatten mit Bauelementen,
- Figur 2: eine andere Seitenansicht des Bestückkopfes nach Figur 1.
Nach den Figuren 1 und 2 besteht ein revolverkopfartiger Bestückkopf 1 aus einem Stator 2 und einem Rotor 3. Der Bestückkopf ist über einer Leiterplatte 4 verfahrbar und weist radial sternförmig abstehende Greifer 5 auf, die mit Saugpipetten versehen sind, an deren freien Enden elektrische Bauelemente 6 gehalten sind. Der Rotor kann schrittweise um einen Indexwinkel verdreht werden, der dem Teilungswinkel der Greifer 5 entspricht. Die Greifer 5 sind teleskopartig aus dem Rotor herausschiebbar. Der jeweils in der Aufsetzstellung befindliche Greifer 5 kann somit das Bauelement 6 in dargestellten senkrechten Pfeilrichtung auf die Leiterplatte 4 aufsetzen.

Die drehbar gelagerten Greifer 5 sind mit scheibenartig geformten Drehkränzen 7 versehen. Eine optische Meßstation 8 dient dem Messen der Lage der Bauelemente 6 gegenüber dem Greifer 5. Entlang der Bewegungsbahn der Drehkränze 7 sind am Stator 2 Reibklötze 9 angebracht, die in der waagerechten Pfeilrichtung soweit ausgelenkt werden können, daß ihre Reibflächen 14 auf die Drehkränze 7 aufgesetzt werden können. Beim Verdrehen des Rotors 3 rollen somit die Drehkränze 7 mit ihren Mantelflächen auf den Reibflächen 14 ab und werden entsprechend verdreht. Dieses Verdrehen geschieht zeitsparend zwischen den Haltestationen des Rotors 3. Die Länge der Reibklötze 9 ist so bemessen, daß die Greifer 5 jeweils um z.B. 45° verdreht werden.

Durch Ein- und Ausschalten der Bremsklotzzustellung kann der Greifer um ein beliebiges Vielfaches des Grobdrehwinkels verdreht werden. Im Anschluß an diese Grobdrehung werden die Bauelemente 6 in der Optikstation vermessen und ihre Abweichung von der Einbaulage bestimmt. Eine nachfolgende Feindreheinrichtung 10 ist einer der Haltestationen zugeordnet. In ihr kann die Drehstellung des Greifers 5 feinstufig verändert und auch die gewünschte Einbaulage des Bauelements korrigiert werden.

Die Reibklötze 9 sind Teil einer Grobdreheinrichtung 11 und mit dieser über piezoelektrische Antriebselemente 12 verbunden, die den Reibklotz 9 in die Richtung des Drehkranzes 7 verstellen.

Anstelle der Grobdreheinrichtung 11 mit den Reibklötzen 8 kann auch eine strichpunktiert angedeutete Grobdrehstation (13) am Stator an einer Haltestation der Greifer 5 angeordnet sein, die gleich der Feindrehstation 10 ausgebildet ist.

### Bezugszeichenliste

- 1: Bestückkopf
- 2: Stator
- 3: Rotor
- 4: Leiterplatte
- 5: Greifer
- 6: Bauelement
- 7: Drehkranz
- 8: Meßstation
- 9: Reibklotz
- 10: Feindreheinrichtung
- 11: Grobdreheinrichtung
- 12: Antriebselement
- 13: Grobdrehstation
- 14: Reibfläche

## Patentansprüche

1. Bestückkopf (1) mit zumindest einer Verdreheinrichtung (10) für elektrische Bauelemente (6), wobei der revolverartige Bestückkopf (1) einen Stator (2) und einen Rotor (3) aufweist, an dem eine Vielzahl von zirkulär verteilten Greifern (5) in sich um eine Aufsetzachse drehbar gelagert sind,
wobei der Bestückkopf eine optische Meßeinrichtung (8) zur Lageerkennung der an den Greifern (5) gehaltenen Bauelemente (6) aufweist,
wobei die Bauelemente nach dem optischen Vermessen durch eine am Bestückkopf angebrachte Feindreheinrichtung (10) genau in die geforderte Aufsetzlage verdrehbar sind,
**dadurch gekennzeichnet,**
**daß** die Bauelemente (6) vor dem Vermessen mittels einer zusätzlich am Bestückkopf angebrachten Grobdreheinrichtung (11) in eine der Aufsetzlage angenäherte Lage verdrehbar sind.

2. Bestückkopf nach Anspruch 1,
**dadurch gekennzeichnet,**
**daß** der Rotor (3) gegenüber dem Stator (2) schrittweise verdrehbar ist,
**daß** die optische Meßeinrichtung als Meßstation (8) und
**daß** die Feindreheinrichtung (10) als am Stator verankerte Feindrehstation (10) ausgebildet ist.

3. Bestückkopf nach Anspruch 2,
**dadurch gekennzeichnet,**
**daß** die am Stator verankerte Grobdreheinrichtung als einer Haltestation der Greifer (5) zugeordnete Grobdrehstation (13) ausgebildet ist.

4. Bestückkopf nach Anspruch 3,
wobei der Greifer (5) einen Drehkranz (7) aufweist, der peripher mit zumindest einer Reibfläche (14) der Verdreheinrichtung (z.B. 10, 11) reibschlüssig in Eingriff bringbar ist,
wobei die Reibfläche (14) in radialer Richtung auf den Drehkranz (7) aufsetzbar ist und
wobei der Greifer (5) durch eine tangentiale Relativbewegung zwischen der Verdreheinrichtung (z.B. 10, 11) und dem Drehkranz (7) verdrehbar ist,
**dadurch gekennzeichnet,**
**daß** sich die stationäre Reibfläche (14)der Grobdreheinrichtung (11) entlang der Bewegungsbahn des zusammen mit dem Rotor (3) verdrehbaren Greifers (5) erstreckt und
**daß** die Abwälzstrecke auf der Reibfläche (14) durch die gesteuerte Zustellung der Reibfläche (14) auf den Drehkranz (7) veranderbar ist.

5. Bestuckkopf nach Anspruch 4,
**dadurch gekennzeichnet,**
**daß** die Grobdreheinrichtung (11) eine Drehverstellung des Greifers (5) in groben Basisschritten ermöglicht.

6. Vorrichtung nach Anspruch 4 oder 5,
**dadurch gekennzeichnet,**
**daß** die Reibfläche (14) an einem am Stator verankerten, radial verstellbaren Reibklotz (9) ausgebildet ist.

7. Einrichtung nach Anspruch 6,
**dadurch gekennzeichnet,**
**daß** die segmentierte Reibfläche (14) von mehreren einzeln verstellbaren Reibklötzen (9) gebildet ist, deren Reiblänge den dem Drehwinkel eines Basisschrittes entspricht.

8. Einrichtung nach Anspruch 6 oder 7,
**dadurch gekennzeichnet,**
**daß** die Reibflächen (14) kürzer sind, als der Abstand zwischen zwei der einander benachbarten Drehkränze (7).

## Claims

1. Insertion head (1) having at least one twisting device (10) for electrical components (6), the turret-like insertion head (1) having a stator (2) and a rotor (3), on which a large number of circularly distributed grippers (5) are mounted such that they can rotate about a mounting axis,
the insertion head having an optical measuring device (8) for detecting the position of the components (6) held on the grippers (5),
it being possible for the components to be twisted accurately into the required mounting position by a precision twisting device (10) fitted to the insertion head after being measured optically,
**characterized in that**, before being measured, the components (6) can be twisted into a position approximating the mounting position by means of a coarse twisting device (11) additionally fitted to the insertion head.

2. Insertion head according to Claim 1, **characterized**
**in that** the rotor (3) can be twisted step by step with respect to the stator (2),
**in that** the optical measuring device is designed as a measuring station (8), and
**in that** the precision twisting device (10) is designed as a precision twisting station (10) anchored to the stator.

3. Insertion head according to Claim 2, **characterized in that** the coarse twisting device anchored to the stator is designed as a coarse twisting station (13) associated with a holding station for the grippers (5).

4. Insertion head according to Claim 3, the gripper (5) having a slewing ring (7), which can be brought peripherally into frictional engagement with at least one friction surface (14) on the twisting device (e.g. 10, 11), it being possible for the friction surface (14) to be placed on the slewing ring (7) in the radial direction and
it being possible for the gripper (5) to be twisted by means of a tangential relative movement between the twisting device (e.g. 10, 11) and the slewing ring (7),
**characterized**
**in that** the stationary friction surface (14) of the coarse twisting device (11) extends along the movement path of the gripper (5) that can be twisted together with the rotor (3), and
**in that** the rolling length on the friction surface (14) can be varied by means of the controlled feed of the friction surface (14) onto the slewing ring (7).

5. Insertion head according to Claim 4, **characterized in that** the coarse twisting device (11) permits a rotational adjustment of the gripper (5) in coarse basic steps.

6. Device according to Claim 4 or 5, **characterized in that** the friction surface (14) is formed on a radially adjustable friction block (9) that is anchored to the stator.

7. Device according to Claim 6, **characterized in that** the segmented friction surface (14) is formed by a plurality of individually adjustable friction blocks (9), whose frictional length corresponds to the the rotational angle of a basic step.

8. Device according to Claim 6 or 7, **characterized in that** the friction surfaces (14) are shorter than the distance between two of the mutually adjacent slewing rings (7).

## Revendications

1. Tête de mise en place (1) comprenant au moins un dispositif (10) de mie en rotation de composants électriques (6), la tête de mise en place (1) de type revolver présentant un stator (2) et un rotor (3) sur lequel est montée une pluralité de dispositifs de saisie (5) répartis en cercle et aptes à tourner autour d'un axe de mise en place, la tête de mise en place présentant un dispositif de mesure optique (8) pour la détection de la position des composants (6) maintenus sur les dispositifs de saisie (5),
les composants pouvant être tournés avec précision dans la position de mise en place imposée par un dispositif de rotation fine (10) installé sur la tête de mise en place, après la mesure optique,
**caractérisée en ce que**
avant la mesure, les composants (6) peuvent être tournés dans une position voisine de la position de mise en place au moyen d'un dispositif de rotation grossière (11) installé en supplément sur la tête de mise en place.

2. Tête de mise en place selon la revendication 1, **caractérisée en ce que** le rotor (3) peut être tourné par pas par rapport au stator (2), **en ce que** le dispositif de mesure optique est configuré comme poste de mesure (8) et **en ce que** le dispositif de rotation fine (10) est configuré comme poste de rotation fine (10) ancré sur le stator.

3. Tête de mise en place selon la revendication 2, **caractérisée en ce que** le poste de rotation grossière ancré sur le stator est configuré comme poste de rotation grossière (13) associé à un poste de maintien des dispositifs de saisie (5).

4. Tête de mise en place selon la revendication 3, dans laquelle le dispositif de saisie (5) présente une couronne rotative (7) dont la périphérie peut être amenée à s'engager à frottement sur au moins une surface de frottement (14) du dispositif de rotation (par exemple 10, 11), la surface de frottement (14) pouvant être placée dans la direction radiale sur la couronne rotative (7), et le dispositif de saisie (5) pouvant être tourné par un déplacement relatif tangentiel entre le dispositif de rotation (par exemple 10, 11) et la couronne rotative (7),
**caractérisée en ce que**
la surface de frottement stationnaire (14) du dispositif de rotation grossière (11) s'étend sur le parcours de déplacement du dispositif de saisie (5) qui peut tourner en même temps que le rotor (3), et **en ce que** le parcours de roulement sur la surface de frottement (14) peut être modifié par l'application asservie de la surface de frottement (14) sur la couronne rotative (7).

5. Tête de mise en place selon la revendication 4, **caractérisée en ce que** le dispositif de rotation grossière (11) permet un déplacement de rotation du dispositif de saisie (5) par pas de base grossiers.

6. Dispositif selon la revendication 4 ou 5, **caractérisé en ce que** la surface de frottement (14) est réalisée sur un galet de frottement (9) ajustable dans le sens radial et ancré sur le stator.

7. Dispositif selon la revendication 6, **caractérisé en ce que** la surface de frottement (14) segmentée est formée de plusieurs galets de frottement (9) ajustables individuellement, dont la longueur de frottement correspond à l'angle de rotation d'un pas de base.

8. Dispositif selon les revendications 6 ou 7, **caractérisé en ce que** les surfaces de frottement (14) sont plus courtes que l'écart entre deux des couronnes rotatives (7) voisines l'une de l'autre.
